# DEMANDE DE BREVET EUROPEEN

(11) **EP 3 882 971 A1**
(43) Date de publication de la demande: **22.09.2021**
(21) Numéro de dépôt: 21161953.1
(22) Date de dépôt: 11.03.2021
(51) Int. Cl.: H01L 27/12, H01L 21/84, H01L 49/02

(54) **SUBSTRAT RF AVEC JONCTIONS AYANT UN AGENCEMENT AMÉLIORÉ**

(30) Priorité: 18.03.2020 FR 2002630
(71) Demandeur: Commissariat à l'énergie atomique et aux énergies alternatives, 75015 Paris (FR)
(72) Inventeur: COLINGE, Jean-Pierre, 38054 Grenoble Cedex 09 (FR); HUTIN, Louis, 38054 Grenoble Cedex 09 (FR); MOULIN, Maxime, 38054 Grenoble Cedex 09 (FR); FACHE, Thibaud, 38054 Grenoble Cedex 09 (FR)
(74) Mandataire: Brevalex

(57) **Abrégé**

Réalisation d'un substrat de type semi-conducteur sur isolant muni d'une structure (20) de blocage de courant Foucault formée dans un secteur dopé (22) selon un dopage d'un premier type, de régions dopées (23) réparties de manière périodique sur une ou plusieurs rangées parallèles et selon un motif (M2) et un agencement amélioré.

## Description

### DOMAINE TECHNIQUE ET ÉTAT DE LA TECHNIQUE ANTÉRIEURE

La présente demande concerne le domaine des substrats semiconducteurs et en particulier ceux destinés à des applications radiofréquences (RF).

Un substrat de type semi-conducteur sur isolant est communément formé d'une couche de support recouverte par, et en contact avec, une couche isolante, elle-même recouverte par, et en contact avec, une couche superficielle semi-conductrice généralement destinée à servir de couche active, c'est-à-dire dans laquelle au moins une partie de composants électroniques tels que des transistors est destinée à être formée.

Pour des applications radiofréquences des adaptations d'un tel substrat peuvent s'avérer nécessaires. Des champs parasites sont en effet susceptibles de venir perturber le fonctionnement du substrat, en particulier lorsque des fréquences élevées par exemple supérieures à 5 GHz, sont utilisées.

Une amélioration connue de ces substrats consiste à former sous et contre la couche isolante communément appelée « BOX » une couche dite « trap rich », c'est-à-dire formée d'un matériau semi-conducteur riche en défauts cristallins et qui permet de piéger des charges.

Avec une telle couche, on limite la conduction parasite à proximité de la couche isolante, et on améliore de cette manière les performances des circuits radiofréquences en termes d'isolation radiofréquences, de diminution des pertes d'insertion et d'intégrité du signal.

Une autre manière de limiter la circulation des courants parasites et en particulier des courants de Foucault (en anglais « eddy currents ») sous la couche isolante et à proximité de l'interface entre cette couche isolante et la couche de support semi-conductrice est proposée dans le document "Low-Loss Si-Substrates Enhanced Using Buried PN Junctions for RF Applications" de Rack et al., IEEE Electron Device Letters, vol. 40, n°5, p. 690, 2019.

Dans ce document, une alternance de bandes dopées 2 de type N et de bandes dopées 4 de type P est réalisée dans la couche de support 6 d'un substrat de type semi-conducteur sur isolant.

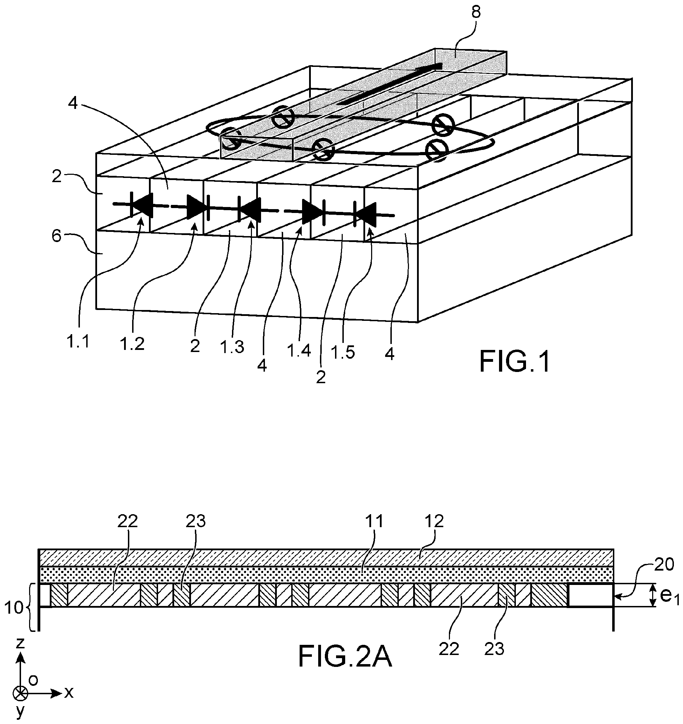

Un tel type d'agencement, illustré sur la figure 1, permet de former des jonctions 1.1, 1.2, 1.3, 1.4, 1.5 prévues pour stopper des courants de Foucault se dirigeant perpendiculairement à une direction principale d'allongement des bandes parallèles 2, 4 dopées N et P.

Dans l'exemple illustré, le circuit conducteur susceptible d'être à l'origine de courants de Foucault est sous forme d'une simple ligne métallique 8 parallèle aux bandes dopées N et P.

Mais un tel agencement des jonctions n'est pas adapté à un cas où le circuit RF prend une forme plus complexe. En effet, dans l'exemple illustré, les jonctions 1.1, 1.2, 1.3, 1.4, 1.5 ne permettraient pas de bloquer des courants de Foucault dans une direction parallèle à celle d'allongement principal des lignes. Il est alors nécessaire de placer la ligne métallique 8 selon une unique disposition sur le support 6, c'est-à-dire perpendiculairement aux bandes dopées 2 et 4.

Il se pose le problème de réaliser une nouvelle structure qui soit améliorée vis-à-vis d'inconvénient(s) mentionné(s) ci-dessus.

### EXPOSÉ DE L'INVENTION

Selon un mode de réalisation, la présente invention prévoit un substrat de type semi-conducteur sur isolant doté d'une couche superficielle semi-conductrice disposée sur une couche isolante, la couche isolante étant agencée sur une couche de support à base de matériau semi-conducteur, ladite couche de support étant dotée d'une structure de blocage de courant formée d'une pluralité de jonctions pour bloquer la circulation de courants parasites dans un plan parallèle à un plan principal de la couche de support,ladite structure comportant, dans un secteur dopé selon un dopage d'un premier type, en particulier P ou N, une pluralité de régions dopées distinctes ayant un dopage d'un deuxième type, en particulier N ou P, opposé audit premier type, lesdites régions dopées étant entourées entièrement d'une zone dudit secteur dopé et de dopage du premier type, lesdites régions formant un motif donné comportant au moins une première branche et au moins une deuxième branche réalisant un angle non-nul avec ladite première branche, le motif donné et la répartition desdites régions dopées dans ledit secteur dopé étant prévus de sorte que :
dans une première direction parallèle au premier axe et traversant ladite structure, ladite structure comporte une ou plusieurs première(s) jonction(s), dans une deuxième direction orthogonale à la première direction et traversant ladite structure, ladite structure comporte une ou plusieurs deuxième(s) jonctions, dans au moins une troisième direction réalisant un angle non-nul avec ladite première direction et deuxième direction et traversant ladite structure, ladite structure comporte une ou plusieurs troisième(s) jonctions.

Une telle structure permet de stopper les courants parasites dans plusieurs directions tout en étant adaptée à différentes formes de composants RF ou de circuits RF ou d'éléments conducteurs acheminant un signal RF.

Elle peut être avantageusement réalisée sans devoir nécessairement prévoir d'aligner précisément lesdits motifs respectifs desdites régions par rapport à la ou les pistes conductrices formant un composant RF ou un circuit RF susceptible d'être à l'origine de courants parasites.

Avantageusement, la structure comporte dans la première direction et/ou dans la deuxième direction, et/ou dans la troisième direction :
une succession de régions dopées formant ledit même motif donné identique en termes de forme et/ou de dimensions.

Typiquement, les régions dopées distinctes peuvent être réparties de manière périodique dans ladite structure sur une ou plusieurs première(s) rangée(s) parallèlement à un premier axe, le premier axe étant parallèle au plan principal du substrat.

Avantageusement, les régions dopées distinctes sont réparties de manière périodique dans ladite structure sur une ou plusieurs autres rangées agencées parallèlement à un deuxième axe, le deuxième axe étant parallèle au plan principal du substrat, le deuxième axe réalisant un angle non-nul avec ledit premier axe.

De préférence, les régions dopées distinctes sont réparties de manière périodique dans ladite structure sur une ou plusieurs rangées parallèlement à un premier axe.

On peut avoir en particulier un agencement matriciel des dites régions dopées, ledit motif donné étant dans ce cas répété selon un agencement matriciel.

De préférence, le motif donné et la répartition des régions dopées sont prévus de sorte que, quel que soit l'axe donné parallèle à la première direction ou à la deuxième direction ou à la troisième direction et passant entre deux dites régions dopées, cet axe donné traverse une succession de jonctions. On limite ainsi de manière optimale les possibilités de création de chemins conducteurs de courants parasites.

Avantageusement, le motif donné a une dimension maximale prévue inférieure et typiquement au moins deux fois inférieure, de préférence au moins dix fois inférieure, à une dimension prédéterminée égale à une longueur maximale de propagation de courant de Foucault dans ledit matériau semi-conducteur de la couche de support à une fréquence de fonctionnement d'un circuit RF qui est apte à être disposé en regard de la structure de blocage.

Selon une possibilité de mise en œuvre, la ou les premières rangées sont formées d'une succession de régions dopées comportant alternativement ledit motif donné suivant une première orientation et ledit motif donné suivant une deuxième orientation distincte de la première orientation.

La structure de blocage peut avantageusement comprendre plusieurs autres rangées parallèles au deuxième axe, au moins une rangée donnée parmi lesdites autres rangées étant formée d'une répétition dudit motif donné suivant la première orientation et au moins une rangée voisine de la rangée donnée étant formée d'une répétition dudit motif donné suivant ladite deuxième orientation.

Avantageusement, le motif donné peut comporter une première branche et une deuxième branche réalisant un angle non-nul avec la première branche, en particulier orthogonale à la première branche.

Selon une deuxième possibilité d'agencement dans lequel lesdites régions dopées distinctes sont réparties de manière périodique dans ladite structure sur une ou plusieurs autres rangées parallèlement à un deuxième axe, le premier axe et ledit deuxième axe étant des axes parallèles audit plan principal, ledit deuxième axe réalisant un angle inférieur à 90° avec ledit premier axe, parmi lesdites premières rangées au moins une rangée donnée étant formée d'une première succession de régions dopées reproduisant ledit motif donné, au moins une rangée voisine de ladite rangée donnée étant formée d'une deuxième succession de régions dopées reproduisant ledit motif donné, ladite rangée voisine étant décalée de ladite rangée donnée par rapport à un plan orthogonal au premier axe et audit plan principal.

Selon une autre possibilité de mise en œuvre du motif donné, celui-ci peut comporter une première branche, une deuxième branche à une première extrémité de la première branche et réalisant un angle non-nul avec la première branche, et une troisième branche à une deuxième extrémité de la première branche et réalisant un angle non-nul avec la première branche, la deuxième branche et la troisième branche ayant des orientations respectives différentes dans un plan parallèle à un plan principal de la couche de support.

Selon une autre possibilité de mise en œuvre du motif donné, celui-ci comporte une première branche principale, une deuxième branche principale, une troisième branche principale, une quatrième branche principale, lesdites branches principales se rejoignant en une région d'intersection, le motif comportant en outre des branches secondaires chacune reliée à une branche principale, les branches secondaires suivant des orientations respectives différentes dans un plan parallèle à un plan principal de la couche de support.

Selon une autre possibilité de mise en œuvre du motif donné, celui-ci est formé d'une succession de branches d'orientations respectives différentes et réalisant une spirale.

Selon une réalisation particulièrement avantageuse, la structure comporte dans la première direction, dans la deuxième direction, dans la troisième direction :
une succession de régions dopées formant ledit même motif donné identique en termes de forme, de dimensions, et d'orientation par rapport à une direction donnée parmi lesdites première direction, deuxième direction, troisième direction.

Selon un autre aspect, la présente invention concerne un dispositif microélectronique comprenant :
- un substrat tel que défini plus haut,
- un ou plusieurs composants électroniques, en particulier un ou plusieurs transistors au moins partiellement formés dans ladite couche superficielle dudit substrat,
- au moins un circuit conducteur RF ou un composant RF, ledit circuit ou ledit composant RF étant agencé en regard dudit secteur dopé.

Typiquement, le composant RF est une antenne et/ou une inductance.

Avantageusement, le motif donné a une dimension maximale mesurée parallèlement au plan principale du substrat, prévue inférieure et typiquement au moins deux fois inférieure, avantageusement au moins dix fois inférieure à une dimension prédéterminée égale à la longueur de propagation de courant de Foucault dans ledit matériau semi-conducteur de la couche de support à ladite fréquence de fonctionnement.

Selon un autre aspect, la présente invention concerne un procédé de fabrication d'un substrat, le procédé comprenant les étapes suivantes :
- réaliser un dopage d'un premier type d'au moins un secteur d'un support semi-conducteur,
- disposer un masque en regard dudit secteur dopé, le masque comprenant des ouvertures ayant une forme reproduisant ledit motif donné,
   - implanter des régions dudit secteur dopé à l'aide d'une espèce dopante de sorte à réaliser un dopage d'un deuxième type opposé au premier type.

Le procédé peut également comprendre après ladite implantation des régions, des étapes de :
- formation d'une couche isolante sur le support semi-conducteur, puis,
- collage sur le support d'un support muni d'une couche semi-conductrice,
- retrait d'une portion sacrificielle du substrat, tandis que la couche semi-conductrice est conservée et forme ladite couche semi-conductrice superficielle.

Selon un autre aspect, la présente invention concerne un procédé de réalisation d'un dispositif RF tel que défini plus haut et comprenant les étapes consistant à :
- prévoir un substrat semi-conducteur sur isolant tel que défini plus haut puis,
- former ledit circuit conducteur RF ou ledit composant RF en regard dudit secteur dopé.

### BRÈVE DESCRIPTION DES DESSINS

La présente invention sera mieux comprise sur la base de la description qui va suivre et des dessins en annexe sur lesquels :
La figure 1 sert à illustrer un substrat SOI avec une structure de blocage de courant de Foucault sous forme d'une alternance de bandes dopées N et P parallèles ;
Les figures 2A-2B servent à illustrer un substrat semi-conducteur avec une structure de blocage de courant de Foucault mise en œuvre suivant un premier exemple de réalisation de la présente invention ;
La figure 3 sert à illustrer un deuxième exemple de réalisation de la présente invention ;
La figure 4 sert à illustrer sert à illustrer un troisième exemple de réalisation de la présente invention ;
La figure 5 sert à illustrer une variante de structure de blocage de courant de Foucault sous forme d'un agencement en damier de zones dopées N et P ;
La figure 6 sert à illustrer une autre variante de structure de blocage de courant de Foucault sous forme d'un agencement matriciel de zones dopées N ayant un motif rectangulaire et réalisées à l'intérieur d'un secteur globalement dopé P ;
La figure 7 sert à illustrer une autre variante d'agencement matriciel de régions dopées N dans un secteur globalement dopé P ;
La figure 8 sert à illustrer un agencement de régions dopées ayant un motif formé de plusieurs branches et réalisées à l'intérieur d'un secteur globalement dopé ayant un type de conductivité opposé à celui desdites régions ;
La figure 9 sert à illustrer un agencement de régions dopées ayant un motif formé de plusieurs branches et réalisées à l'intérieur d'un secteur globalement dopé ayant un type de conductivité opposé à celui desdites régions ;
La figure 10 sert à illustrer sert à illustrer un exemple de réalisation de structure de blocage de courants de Foucault suivant la présente invention, avec une portion d'antenne ou d'inductance en regard de cette structure ;
Les figures 11A-11B servent à illustrer des exemples de composants RF destinés à être placé en regard d'une structure de blocage de courant de Foucault telle que mise en œuvre suivant l'invention;
Les figures 12A, 12B, 12C servent à illustrer un procédé de fabrication d'un substrat de type semi-conducteur sur isolant muni d'une structure de blocage de courants de Foucault telle que mise en œuvre suivant un mode de réalisation de la présente invention ;
La figure 13 sert à illustrer un dispositif microélectronique doté d'un substrat de type semi-conducteur sur isolant muni d'une structure de blocage de courants de Foucault dans la couche de support et en regard de laquelle un composant ou circuit RF est formé ;
La figure 14 sert à illustrer un dispositif microélectronique doté d'un substrat avec une structure de blocage de courants de Foucault localisée dans une région, tandis qu'une autre région dépourvue de BOX est dédiée à un circuit doté de composants logiques ;
La figure 15 sert à illustrer un agencement de régions dopées formé de plusieurs branches réalisant un motif en spirale à l'intérieur d'un secteur globalement dopé ayant un type de dopage opposé à celui desdites régions ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de réalisation d'une structure de blocage de courant parasites, en particulier de courants de Foucault, dans un substrat tel que mis en œuvre suivant un mode de réalisation de la présente invention, va à présent être donné en liaison avec les figures 2A-2B (donnant respectivement une vue en coupe transversale du substrat avec la structure de blocage et une vue de dessus de cette structure).

La structure est réalisée dans une partie supérieure d'une couche de support 10 semi-conductrice d'un substrat, par exemple de type semi-conducteur sur isolant. Cette structure se présente sous forme d'un volume 20 dopé, de la couche 10 de support et est disposée contre, et de préférence en contact avec la couche isolante 11 du substrat. La couche isolante 11 est agencée sur la couche de support 10 et sépare cette couche de support 10 d'une couche semi-conductrice superficielle 12 dans laquelle des canaux de transistors peuvent être prévus.

Le substrat peut être en particulier de type SOI (« Silicon On Insulator », i.e. « silicium sur isolant ») c'est-à-dire avec une couche semi-conductrice 12 superficielle en silicium.

Par exemple, la couche superficielle semi-conductrice 12 peut être prévue avec une épaisseur comprise entre 4 nm et 50 nm. La couche isolante 11 est quant à elle typiquement à base d'oxyde de silicium et peut avoir une épaisseur comprise par exemple entre 15 nm et 250 nm.

La couche de support 10 semi-conductrice peut être également en silicium et comporter sous le volume 20 dopé une couche de matériau semi-conducteur de résistivité élevée, par exemple supérieure à 1000 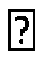 cm, et avantageusement supérieure à 5000 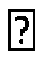 cm.

Le volume 20 dopé peut quant à lui avoir une épaisseur e₁ (dimension mesurée parallèlement à l'axe z d'un repère orthogonal [0;x;y;z] indiqué sur les figures) comprise par exemple entre 50 nm et 1 µm, avantageusement entre 100 nm et 500 nm.

Le volume 20 dopé est ici formé d'un secteur dopé 22 selon un dopage d'un premier type, conférant un premier type de conductivité par exemple de type P, et d'une pluralité de régions 23 dopées. On prévoit dans la structure de blocage une répétition de régions dopées 23 distinctes entre elles réalisant un même motif M₁, M'₁ identique en termes de taille et de forme.

Par « distinctes » on entend ici des régions non contiguës entre elles ou qui ne se touchent pas, et qui sont entourées par ledit secteur 22. Les régions dopées 23 ont un dopage d'un deuxième type, conférant un deuxième type de conductivité opposé audit premier type de conductivité, par exemple de type N. Par dopage de type N, on entend un dopage qui consiste à installer un excès d'électrons, tandis que par dopage de type P, on entend un dopage qui consiste à installer un excès de trous. On a donc, dans cet exemple, un secteur 22 dopé P et des régions 23 dopées N qui sont entourées par ce secteur 22.

Les régions 23 dopées sont ainsi entourées, de préférence entièrement entourées, de portions dudit secteur dopé 22 ayant un dopage de type opposé. Le volume 20 comporte ainsi des jonctions 25a, 25b PN ou NP formées chacune, entre d'une part une zone du secteur 22 dopé selon ledit dopage du premier type et d'autre part une desdites régions dopées 23 selon le dopage du deuxième type ou inversement.

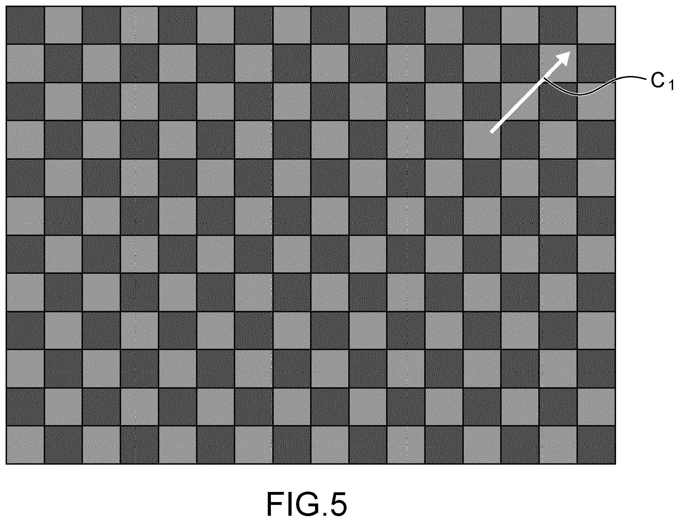

Une telle disposition participe à limiter voire empêcher la propagation de courant de Foucault parasite du type de celui référencé C₁ sur la figure 5. Dans un tel agencement en damier illustré sur cette figure 5, un courant parasite est en effet susceptible de traverser des régions dopées contiguës selon une diagonale, par rapport aux rangées longitudinales et transversales du damier.

Dans l'exemple de réalisation particulier des figures 2A-2B, la succession de motifs dopés est telle que les régions dopées 23 sont réparties de manière périodique dans la structure sur au moins une rangée 31, 32, 33. Ces régions 23 peuvent être, elles-mêmes disposées sur plusieurs rangées agencées parallèlement à un premier axe Δ₁, cet axe Δ₁ étant parallèle à un plan principal du substrat. Par « plan principal » du substrat, on entend ici un plan passant par le substrat et qui est parallèle au plan [O;x;y] donné sur les figures.

Un agencement matriciel de régions dopées 23 réparties en lignes et en colonnes peut être en particulier prévu. Ainsi, dans l'exemple de réalisation particulier illustré, les régions dopées 23 sont également réparties en rangées 31 parallèlement à un deuxième axe Δ₂, ce deuxième axe étant dans cet exemple parallèle au plan principal du substrat et orthogonal au premier axe Δ₁.

L'agencement périodique des régions 23 est tel que dans une première direction parallèle au premier axe Δ₁, ladite structure comporte une ou plusieurs jonctions 25a, 25b, permettant de bloquer des courants parasites dans cette première direction, tandis que dans une deuxième direction orthogonale à la première direction et parallèle au deuxième axe Δ₂, ladite structure comporte une ou plusieurs jonctions 25a, 25b permettant de bloquer des courants parasites dans cette deuxième direction, et que dans au moins une troisième direction parallèle à un troisième axe Δ₃ et réalisant un angle non-nul, par exemple de 45°, avec lesdites première et deuxième directions et traversant ladite structure, ladite structure comporte une ou plusieurs jonctions 25a, 25b permettant de bloquer des courants parasites dans cette troisième direction.

Dans la mesure où la longueur de propagation Ip des courants de Foucault dépend de la fréquence de fonctionnement du circuit RF, on adapte l'étendue (autrement dit l'empreinte ou la surface occupée) de la structure de blocage ou du volume dopée mesuré(e) dans un plan parallèle au plan principal du substrat, en fonction de celle du composant RF par exemple de type antenne ou inductance et de cette fréquence de fonctionnement. L'étendue de la structure de blocage est ainsi de préférence supérieure à celle de l'antenne et par exemple, pour une antenne de 30Ghz, un dépassement L_{D} ≥ Ip d'au moins 1 mm, représentant la longueur maximale de propagation des courants de Foucault, est prévu.

On prévoit également de préférence l'agencement des régions dopées 23 et leur taille de sorte qu'en regard de l'antenne, un segment de longueur égal à ladite longueur de propagation Ip est entrecoupé par au moins une jonction PN et au moins une jonction NP.

Pour cela, on peut prévoir par exemple la longueur maximale des régions dopées 23, autrement dit la dimension maximale D_{M} des motifs M₁, M'₁ mesurée parallèlement au plan [0 ;x ;y] du repère orthogonal [0;x;y;z] en fonction de la dimension Ip et de préférence de sorte que 2^{∗}D_{M} ≤ Ip. Typiquement, la dimension maximale D_{M} est bien inférieure, c'est-à-dire au moins 10 fois inférieure aux dimensions de l'antenne et à la longueur Ip de propagation.

Ainsi, un dispositif muni d'une telle structure de blocage présente un grand nombre de jonctions permettant de bloquer des courants parasites dans au moins 3 directions différentes (par exemple 45° de différence).

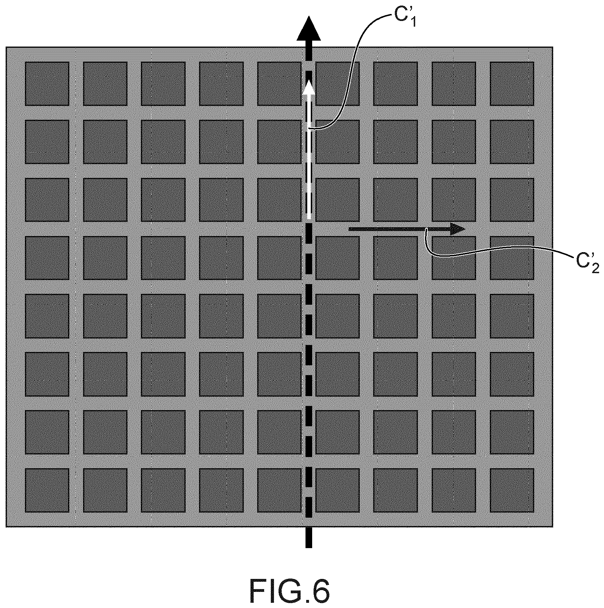

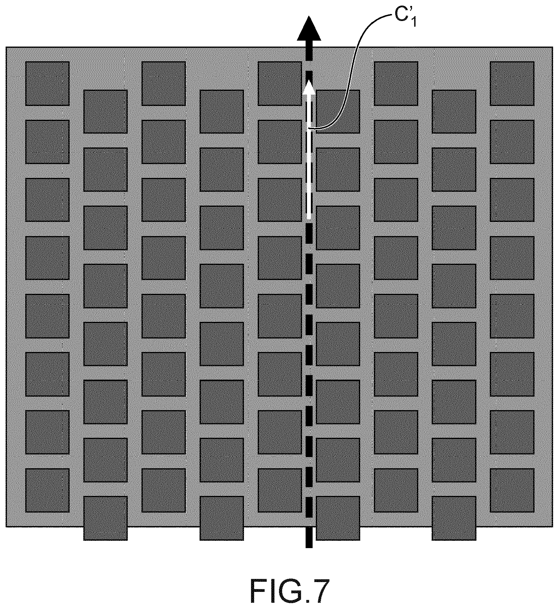

Les régions dopées 23 de type N suivent de préférence un même motif M₁, M'₁. Dans l'exemple illustré, ce motif M₁, M'₁ est formé d'au moins une première branche b₁ et d'au moins une deuxième branche b₂ reliée à la première branche b₁ et réalisant un angle non-nul avec la première branche b₁. On se distingue ainsi de motifs de forme rectangulaire ou carré tels que par exemple ceux montrés sur les figures 6, 7 et qui, dans un agencement matriciel en damier favoriseraient la formation de chemins de courants parasites C'₁, C'₂. Avec une telle forme de motifs, on limite la possibilité de création de chemins de courants parasites.

La première branche b₁ et/ou la deuxième branche b₂ du motif M₁, M'₁ peut être prévue avec une dimension critique dc (dimension mesurée parallèlement au plan [0 ;x ;y] correspondant à la plus petite dimension d'un motif hormis son épaisseur) comprise par exemple entre 500 nm et 10 µm, avantageusement entre 1 µm et 5 µm

Par exemple, on peut prévoir une dimension maximale D_{M} comprise entre 5 µm et 100 µm, avantageusement entre 25 µm et 50 µm, tandis qu'un espace minimal dₘᵢₙ compris entre 500 nm et 10 µm, avantageusement entre 1 µm et 5 µm peut être prévu pour des pistes de largeur comprise entre 500 nm et 10 µm

La répétition et la répartition en rangées des régions dopées 23 selon un motif ou selon une même séquence de motifs déterminé(e), permet de prévoir un composant RF ou circuit conducteur RF ou un élément conducteur en regard du volume 20 dopé sans nécessairement devoir réaliser un alignement précis de ce composant ou de ce circuit ou de cet élément conducteur par rapport aux jonctions et en particulier aux frontières des régions 23 dopées. La structure de blocage peut être ainsi avantageusement conçue sans nécessairement connaitre au préalable le dessin exact du circuit RF ou composant RF amené à être réalisé en regard du volume dopé 20. Les dimensions des pistes formant le circuit ou composant RF ainsi que l'encombrement global de ce composant ou de circuit peuvent alors suffire.

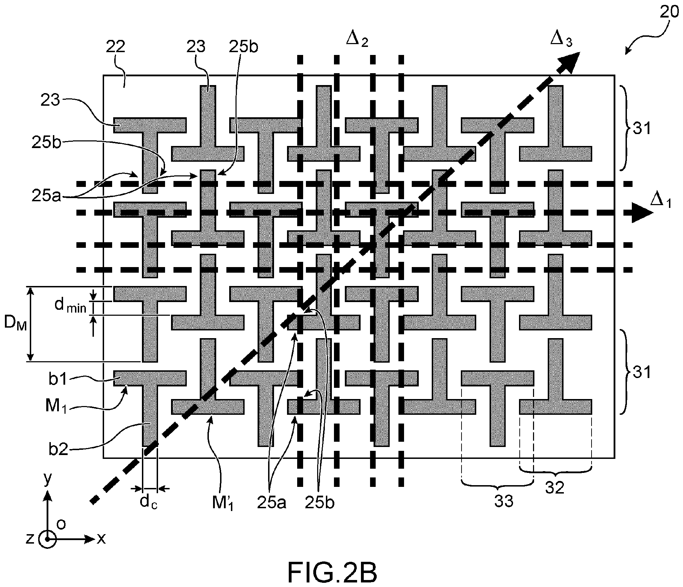

Dans l'exemple de réalisation particulier illustré sur la figure 2B, le motif M₁, M'₁ reproduit dans un agencement matriciel est un motif en forme de 'T', avec une alternance de rangées 32 dans lesquels le motif M₁ présente une première orientation par rapport à l'axe Δ₁ et de rangées 33 dans lesquels le motif M'₁ suit une deuxième orientation, les motifs M₁, M'₁ d'une rangée 32 étant dans cet exemple d'agencement particulier disposés tête-bêche, c'est-à-dire selon une rotation de 180°, par rapport à ceux M'₁ de la rangée 33 voisine.

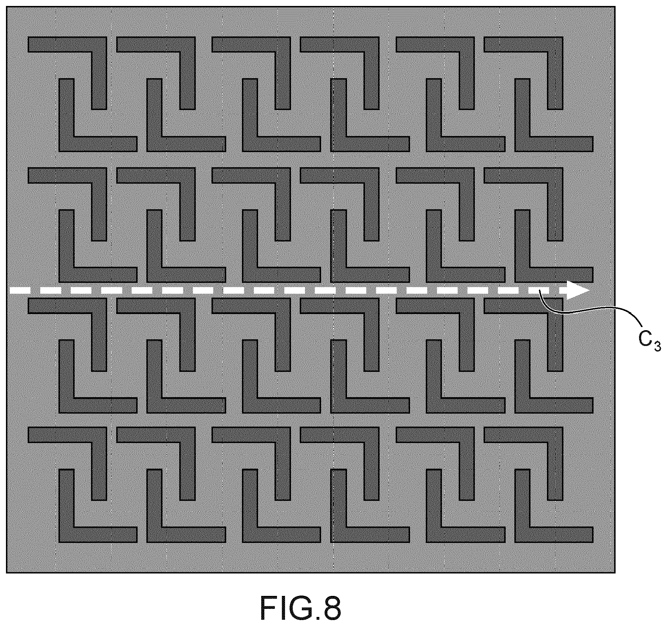

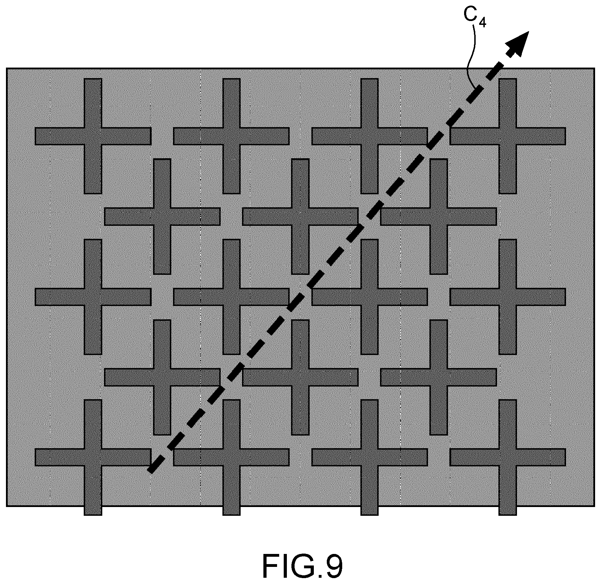

Toutefois, d'autres agencements et formes de motifs peuvent être prévus. La figure 2B permet d'illustrer un mode avantageux notamment par rapport à ceux illustrés sur les figures 8 et 9, où d'autres types de motifs en forme de 'L' et en forme de croix simple, ou de '+', ou de motif constitué de quatre branches sont utilisés.

Dans l'exemple de réalisation illustré sur la figure 2B, l'agencement des motifs M₁, M'₁ et leur forme sont déterminés de sorte que quel que soit l'axe donné parallèle au premier axe Δ₁, ou au deuxième axe Δ₂ ou au troisième axe Δ₃ traversant la structure et passant par une zone du secteur 22 entre deux régions dopées 23 voisines, cet axe donné rencontre une alternance de zones dopées de type N et de zone dopée de type P, avec au moins une jonction PN et au moins une jonction NP. Des chemins conducteurs parasites tels que ceux C₃, C₄ représentés de manière schématique sur les figures 8 et 9 sont ainsi évités.

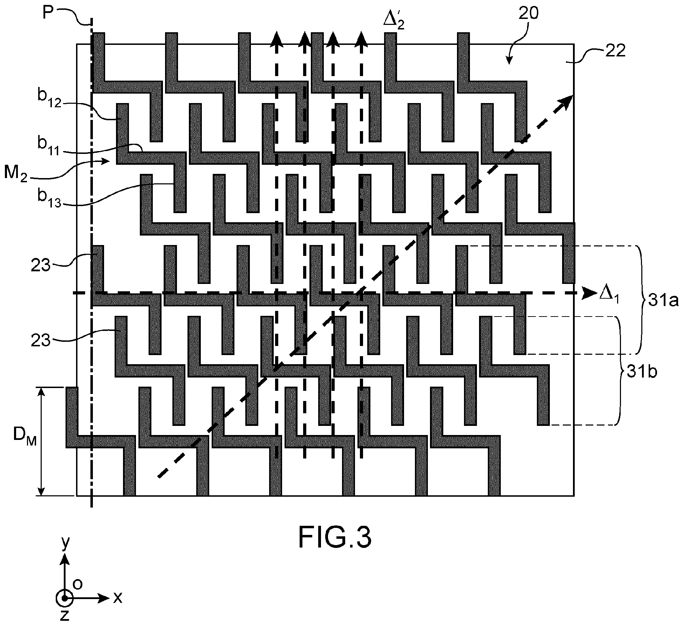

Un deuxième exemple de la structure de blocage est donné sur la figure 3. Il diffère de l'exemple précédemment décrit, notamment de par la forme des régions dopées 23, ainsi que de par leur répartition dans le secteur dopé 22.

Les régions dopées 23 ont ici un motif M₂ identique répété, avantageusement de manière périodique, et de préférence selon un agencement matriciel dans lequel la répétition de motifs est réalisée sur plusieurs axes Δ₁, Δ'₂.

Le motif M₂ comporte, dans cet exemple particulier, une première branche b₁₁, une deuxième branche b₁₂ située à une première extrémité de la première branche b₁₁ et une troisième branche b₁₃ située à une deuxième extrémité de la première branche b₁₁. Les branches b₁₂ et b₁₃ réalisent un angle non-nul, par exemple de 90° avec la première branche b₁₁. Selon l'exemple illustré, la deuxième branche b12 et la troisième b13 présentent des directions d'allongement parallèles et selon des sens respectifs opposés. Autrement dit, le motif M₂ n'est, ici, pas en forme de U. Un tel motif M₂ à plusieurs branches s'étendant dans des directions différentes (par rapport à b11) participe à la mise en œuvre d'un blocage de courant dans plusieurs directions.

Comme dans l'exemple précédent, un agencement régulier des régions 23 en lignes parallèles à un premier axe Δ₁ est prévu. Toutefois, dans cet exemple de réalisation particulier, un décalage de positionnement des motifs est mis en œuvre entre des rangées voisines 31a, 31b successives parallèles au premier axe Δ₁. Le décalage entre rangées voisines est ici un décalage pris par rapport à un plan P orthogonal au plan principal du substrat et orthogonal au premier axe Δ₁.

Ainsi, une rangée donnée 31a formée d'une succession de motifs M₂, est, par rapport à un axe orthogonal au premier axe Δ₁ décalé par rapport à une rangée voisine de ladite rangée donnée formée d'une autre succession dudit même motif donné M₂. Une répartition des motifs M₂ en rangées parallèles à un deuxième axe Δ'₂ non-orthogonal au premier axe est ici réalisée.

De par la forme et l'agencement des régions 23, en particulier leur répartition et la répétition périodique, la structure de blocage de courants parasites peut, comme dans l'exemple de réalisation précédent, être réalisée sans connaissance précise de l'agencement des pistes du circuit RF ou du composant RF. Par ailleurs, là encore, on met en œuvre un blocage selon au moins 3 directions distinctes, en particulier à au moins 45° les unes par rapport aux autres.

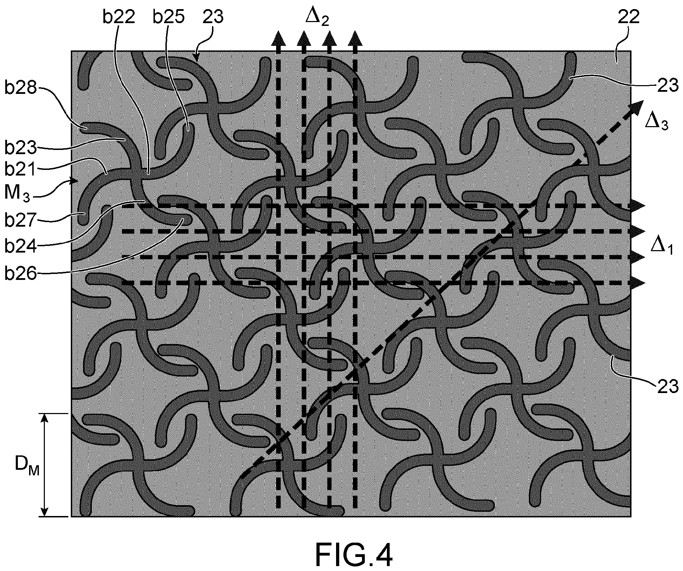

Un troisième exemple de réalisation d'une structure de blocage est donné sur la figure 4. Il diffère de l'exemple précédent notamment de par la forme des régions dopées 23.

Les régions dopées 23 ont ici un motif M₃ formé de quatre banches b₂₁, b₂₂, b₂₃, b₂₄ principales se rejoignant en une région d'intersection et de quatre branches b₂₅, b₂₆, b₂₇, b₂₈ secondaires chacune située à une extrémité respective d'une branche principale b₂₁, b₂₂, b₂₃, b₂₄, les branches secondaires b₂₅, b₂₆, b₂₇, b₂₈ suivant des orientations respectives différentes.

Un tel motif M₃ permet de faciliter un agencement dans lequel des branches de motifs voisins s'interpénètrent pour créer des zones du secteur dopé 22 selon le dopage du premier type et réalisant un parcours sinueux. Cela contribue à limiter voire empêcher la circulation de courants de Foucault.

Dans l'exemple de réalisation illustré sur la figure 4, le motif a été représenté sans angle mais l'Homme du Métier saura adapter ce motif avec un angle, en particulier droit, entre une branche principale et sa branche secondaire afin de réaliser ce motif avec les techniques de lithographie dont on dispose actuellement.

Par exemple, le motif M₃ est semblable à celui d'un svastika mais d'autres motifs à branches principales et secondaires peuvent être utilisés. Par exemple, on peut voir un motif dans lequel les branches principales réalisent entre elles un angle différent de 90° et/ou dans lequel les branches secondaires b₂₅, b₂₆, b₂₇, b₂₈ réalisent un angle différent de 90° avec les branches principales et/ou dans lequel d'autres branches dites « tertiaires » issues des branches secondaires réalisent un angle non-nul avec ses dernières.

Comme dans l'exemple décrit précédemment, la répartition régulière selon un pas prédéterminé des motifs M₃, permet de réaliser une structure de blocage permettant d'empêcher la circulation de courant de Foucault sans devoir connaitre nécessairement à l'avance la disposition des pistes conductrices d'un circuit RF ou d'un composant RF (tel qu'une antenne) destiné à être positionné en regard du volume dopé 20.

Dans l'un ou l'autre des modes de réalisation précédemment décrits, il est possible de réaliser un secteur 22 dopé N tandis que les régions 23 situées à l'intérieur de ce secteur 22 sont dopées P. Inversement, on peut réaliser un secteur 22 dopé P tandis que les régions 23 intégrées dans ce secteur 22 sont dopées N.

Dans l'exemple de réalisation illustré sur la figure 4 comme dans les autres exemples de réalisation décrits précédemment, une structure de blocage qui comporte dans la première direction, dans la deuxième direction, dans la troisième direction : une succession de régions dopées formant ledit même motif donné identique en termes de forme, de dimensions, et éventuellement d'orientation par rapport à une direction donnée parmi lesdites première direction, deuxième direction, troisième direction est particulièrement avantageuse. On réalise un blocage optimal tout en évitant le problème d'alignement avec un composant passif ou une antenne. Selon une réalisation, une structure de blocage comporte dans la première direction, dans la deuxième direction, dans la troisième direction : une succession de régions dopées formant ledit même motif donné identique en termes de forme, de dimensions, et d'orientation par rapport à une direction donnée parmi lesdites première direction, deuxième direction, troisième direction.

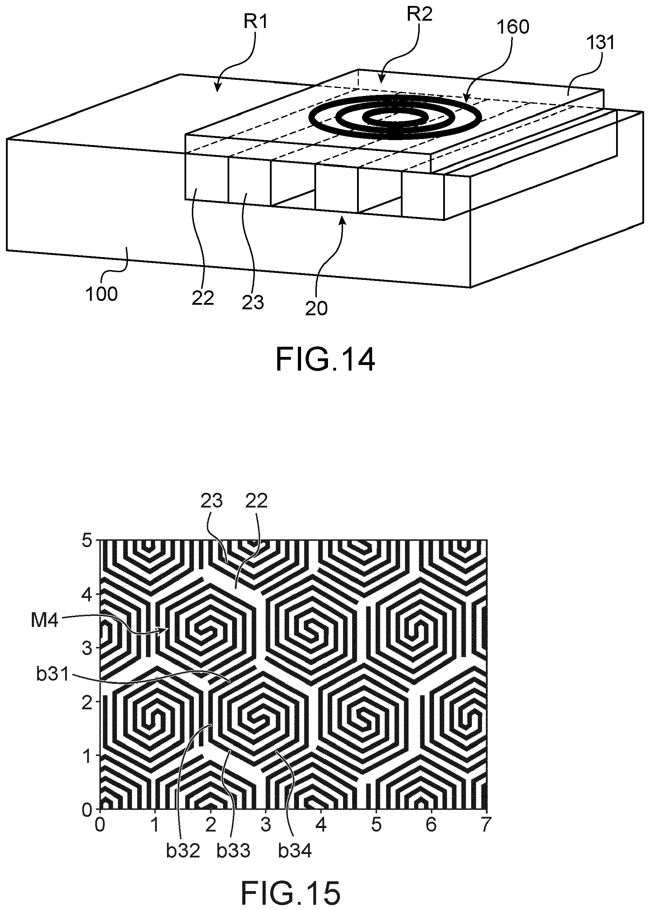

Un autre exemple de réalisation d'une structure de blocage est donné sur la figure 15. Il diffère de par la forme des régions dopées 23. Les régions dopées 23 réalisent ici un motif M₄ en forme de spirale composé d'une succession de branches b₃₁, b₃₂, b₃₃, b₃₄... distinctes d'orientations différentes entre elles. Les branches ici sous formes de spires ne se touchent pas entre elles, ni d'un motif M₄ à l'autre. Les branches peuvent avoir une dimension critique par exemple de l'ordre de 100 nm, le motif en spirale ayant une dimension maximale par exemple de l'ordre de 1.5 µm, bien inférieur à celui d'un composant passif de type inductance ou antenne.

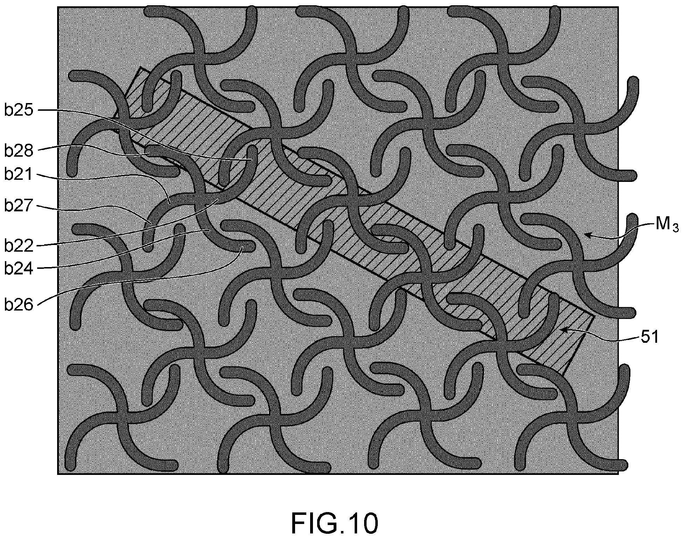

Dans l'exemple d'agencement illustré sur la figure 10 (donnant une vue de dessus), une piste conductrice 51 par exemple d'une antenne ou d'une inductance, par laquelle un signal RF est destiné à transiter est positionnée au-dessus et en regard du volume dopé 20 dans lequel la succession répétée de jonctions PN et/ou NP est réalisée. Cette piste conductrice 51 peut être positionnée sans être nécessairement alignée avec et/ou sans tenir compte de l'orientation de l'une ou l'autre des branches b₂₁, b₂₂, b₂₃, b₂₄, b₂₅, b₂₆, b₂₇, b₂₈ du ou des motifs M₃ de la structure de blocage.

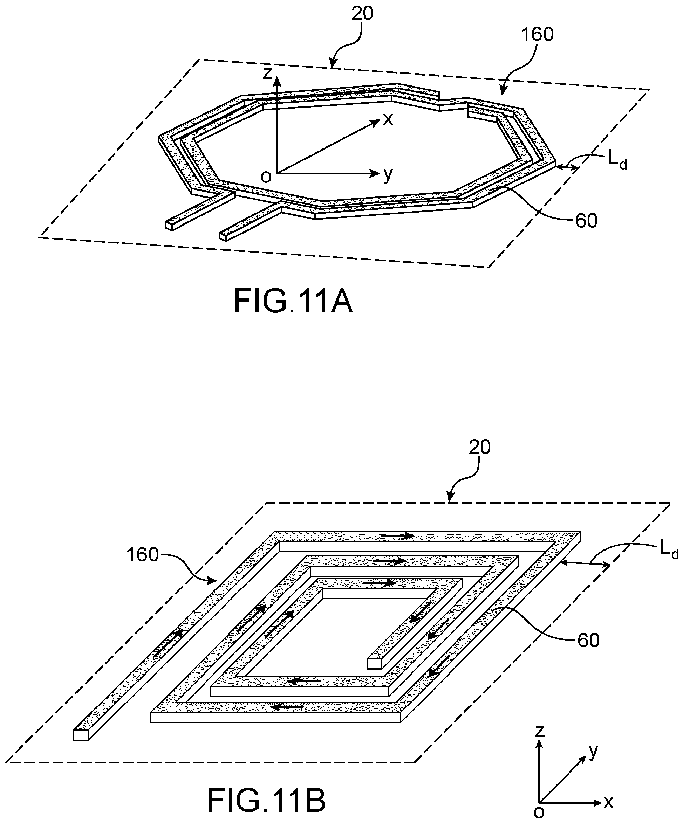

Par exemple, la piste conductrice 51 peut être une portion d'inductance 160 réalisant une boucle de la forme d'un polygone tel qu'illustrée sur la figure 11A ou celle globalement rectangulaire sur la figure 11B. Dans ce cas, la connaissance de la surface occupée par l'inductance 160 et de la largeur de piste 60 permet de réaliser la structure 20 de blocage sans connaitre nécessairement l'orientation des pistes conductrices par rapport aux motifs dopés.

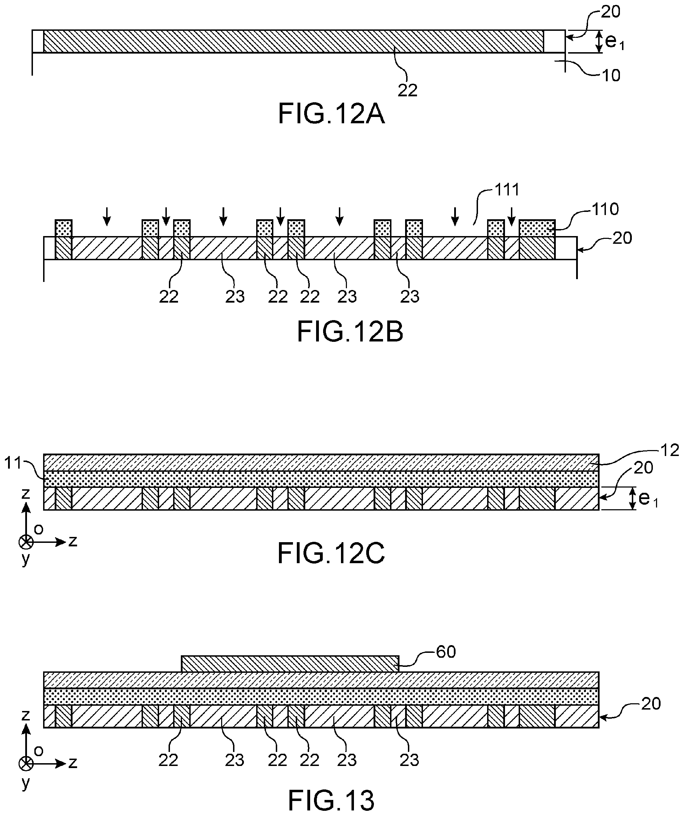

Un exemple de procédé de réalisation d'une structure de blocage de courants parasites pour substrat semi-conducteur sur isolant et qui peut être du type d'un des modes de réalisations précédemment décrits, va à présent être donné en liaison avec les figures 12A-12C.

Un matériau de départ possible pour ce procédé est ici un substrat massif, autrement dit de type communément appelé « bulk » formé d'une tranche de matériau semi-conducteur. Le substrat massif est ici destiné à former la couche de support dans laquelle la structure de blocage est réalisée.

Une couche superficielle de cette couche de support 10 peut être tout d'abord dopée, par exemple par implantation, pour réaliser le secteur dopé 22 (figure 12A). Pour cela, un dopage d'un premier type est effectué de sorte à former un secteur dopé 22. Par exemple, si l'on effectue un dopage à l'aide d'une espèce accepteuse, on réalise un secteur 22 ayant un dopage de type P.

Pour former un secteur 22 dopé P dans la couche de support 10, on peut par exemple effectuer une implantation de Bore selon une énergie comprise par exemple entre 10 keV et 150 keV, et une dose comprise par exemple entre 10¹⁴ cm⁻² et 10¹⁵ cm⁻².

Ensuite, on prévoit un masque 110 à implantation comportant des ouvertures 111 distinctes reproduisant chacune un motif donné, par exemple l'un des motifs M₁, M₂, M₃ décrits précédemment. Le masque 110 peut être par exemple à base de résine dans laquelle on pratique les ouvertures 111 par exemple au moyen d'un procédé de photolithographie.

On forme ensuite les régions 23 dopées selon un dopage de type opposé. Par exemple, si l'on effectue une implantation à l'aide d'une espèce donneuse à travers les ouvertures 111 du masque 110, on peut réaliser des régions 23 ayant un dopage de type N (figure 12B) dans les parties exposées par les ouvertures 111.

Pour réaliser des régions 23 dopées N dans le secteur 22 dopé P, on peut par exemple effectuer une implantation de Phosphore selon une énergie comprise par exemple entre 20 keV et 200 keV, et une dose comprise par exemple entre 10¹⁴ cm⁻² et 10¹⁵ cm⁻².

Selon un autre exemple de réalisation une implantation d'Arsenic selon une énergie comprise par exemple entre 40 keV et 200 keV, et une dose comprise par exemple entre 10¹⁴ cm⁻² et 10¹⁵ cm⁻² peut être effectuée pour former les régions 23.

La dose utilisée pour former les régions dopées 23 est de préférence supérieure à celle du secteur dopé 22, afin de pouvoir inverser localement le type de conductivité dans les régions dopées 23 et pouvoir créer des régions dopées P dans un secteur globalement dopé N ou inversement des régions dopées N dans un secteur globalement dopé P.

Le masque 110 peut être ensuite retiré. Par exemple, dans un cas où le masque 110 est à base de résine photosensible, on peut retirer ce masque 110 par gravure à l'aide d'un plasma d'oxygène et/ou d'un bain contenant un mélange d'acide sulfurique et d'eau oxygénée. Il peut avantageusement être utilisé un masque « dur », par exemple d'oxyde ou de nitrure de silicium, préalablement gravé par photolithographie et gravure, par exemple par plasma. Le masque dur peut ensuite être enlevé par voie chimique, en utilisant une solution de HF pour un masque en oxyde ou du H₃PO₄ pour un masque de nitrure.

On peut ensuite former une couche isolante 11 sur la couche de support 10, par exemple par dépôt d'oxyde de silicium.

Puis, on reporte une couche semi-conductrice 12 destinée à former la couche superficielle du substrat semi-conducteur sur isolant. Cette couche superficielle peut être réalisée par exemple par report d'un support semi-conducteur poignée, par exemple en silicium, que l'on colle sur la couche isolante 11 typiquement en effectuant un collage par adhérence moléculaire. Une couche d'oxyde peut être éventuellement prévue sur ce support poignée afin de réaliser un collage de type oxyde sur oxyde. Une zone de fragilisation est réalisée dans le support poignée par exemple en effectuant une implantation du support poignée. Ensuite, on peut effectuer une séparation d'une épaisseur du support poignée au niveau de la zone de fragilisation, de manière à conserver une autre épaisseur de ce support qui forme alors la couche semi-conductrice superficielle 12 (figure 12C). Ainsi, la couche superficielle 12 peut être réalisée à l'aide d'un procédé de type communément appelé Smart cut™. Le substrat semi-conducteur sur isolant est alors prêt à accueillir un ou plusieurs composants électroniques ainsi qu'au moins un composant RF ou circuit RF.

En variante de l'exemple de procédé qui vient d'être décrit, on peut former les jonctions directement dans la couche de support d'un substrat de type semi-conducteur sur isolant, par exemple à l'aide d'une première implantation pour réaliser le secteur dopé 22 puis une autre implantation à travers les ouvertures d'un masque pour réaliser les régions dopées 23.

Une étape ultérieure de formation de pistes conductrices 60 de ce composant RF ou circuit RF par réalisation d'un premier niveau métallique est illustrée sur la figure 12. Le circuit RF est typiquement réalisé sur au moins deux niveaux de métallisation, avec une ou plusieurs pistes conductrices d'un premier niveau reliées à une ou plusieurs pistes conductrices d'un deuxième niveau. La structure de blocage formée de jonctions PN ou NP et telle que mise en œuvre suivant l'invention peut alors permettre d'empêcher la circulation de courants parasites susceptibles d'être générés par une circulation de courant sur chacun des niveaux de métallisation du circuit RF.

Comme cela a été décrit précédemment, une structure de blocage de courant de Foucault telle que mise en œuvre suivant l'invention peut être agencée sur un substrat de type semi-conducteur sur isolant, ou bien sur un substrat massif sur lequel une couche isolante est typiquement rajoutée.

Dans un autre exemple de réalisation illustré sur la figure 14, le volume dopé 20 dans lequel la structure de blocage est réalisée, est formé dans la couche de support 100 semi-conductrice d'un substrat et en regard d'une région R₂ sur laquelle s'étend une couche isolante 131 par exemple d'oxyde de silicium et d'épaisseur qui peut être comprise par exemple entre 50 nm et 1 µm Le composant RF 160, par exemple sous forme d'antenne, est agencé sur cette couche isolante 131, tandis qu'une autre région R₁ de la couche de support 100 n'est, quant à elle, pas recouverte par la couche isolante 111. Cette autre région R₂ peut être dédiée à d'autres types de composants et/ou circuits. Par exemple, on peut prévoir des composants logiques sur cette autre région R₁.

## Revendications

1. Substrat pour dispositif RF, le substrat étant doté d'une couche superficielle semi-conductrice (12) disposée sur une couche isolante (11), la couche isolante étant agencée sur une couche de support (10) à base de matériau semi-conducteur, ladite couche de support étant dotée d'une structure (20) de blocage de courants de Foucault susceptibles d'être générés par un circuit RF destiné à être disposé sur le substrat, ladite structure de blocage étant formée d'une pluralité de jonctions (25a, 25b) pour bloquer une circulation de courants de Foucault, ladite structure (20) de blocage comprenant, dans un secteur dopé (22) selon un dopage d'un premier type, en particulier P ou N : une pluralité de régions (23) dopées distinctes ayant un dopage d'un deuxième type opposé au premier type, en particulier N ou P, lesdites régions dopées (23) ayant un dopage du deuxième type étant chacune entourées entièrement d'une zone dudit secteur dopé (22) et de dopage du premier type, et lesdites régions (23) ayant un dopage du deuxième type et réalisant chacune un motif donné (M₁, M'₁, M₂, M₃, M₄,) formé d'au moins une première branche (b₁, b₁₁, b₂₁, b₃₁) et d'au moins une deuxième branche (b₂, b₁₂, b₂₂, b₃₂) réalisant un angle non-nul avec ladite première branche, ledit motif donné étant entouré entièrement de ladite zone dudit secteur dopé (22) et de dopage du premier type, le motif donné (M₁, M'₁, M₂, M₃) et la répartition desdites régions (23) dopées dans ledit secteur dopé étant prévus de sorte que : dans une première direction parallèle au premier axe (Δ₁) et traversant ladite structure, ladite structure comporte une ou plusieurs première(s) jonction(s) (25a, 25b), dans une deuxième direction orthogonale à la première direction et traversant ladite structure ladite structure comporte une ou plusieurs deuxième(s) jonctions, dans au moins une troisième direction réalisant un angle non-nul avec ladite première et deuxième directions et traversant ladite structure, ladite structure comporte une ou plusieurs troisième(s) jonctions.

2. Substrat selon la revendication 1, ladite structure (20) comportant dans ladite première direction et/ou dans ladite deuxième direction et/ou dans ladite troisième direction : une succession de régions dopées (23) ayant un dopage du deuxième type et réalisant ledit même motif donné identique.

3. Substrat selon l'une des revendications 1 ou 2, lesdites régions dopées (23) distinctes étant réparties de manière périodique dans ladite structure sur une ou plusieurs première(s) rangée(s) (31, 31a, 31b) parallèlement à un premier axe (Δ₁).

4. Substrat selon la revendication 3, dans lequel lesdites régions dopées distinctes (23) sont réparties de manière périodique dans ladite structure sur une ou plusieurs autres rangées agencées parallèlement à un deuxième axe (Δ₂), ledit premier axe (Δ₁) et ledit deuxième axe (Δ₂) étant parallèles audit plan principal, ledit deuxième axe (Δ₂) réalisant un angle non-nul avec ledit premier axe.

5. Substrat selon l'une des revendication 1 à 4, dans lequel ledit motif donné a une dimension maximale prévue inférieure et typiquement au moins deux fois inférieure, avantageusement au moins dix fois inférieure, à une dimension prédéterminée égale à une longueur maximale de propagation de courant de Foucault dans ledit matériau semi-conducteur de la couche de support à une fréquence de fonctionnement d'un circuit RF apte à être disposé en regard de l'antenne.

6. Substrat selon l'une des revendications 1 à 5, la ou les premières rangées (31) étant formées d'une succession de régions dopées (23) comportant alternativement ledit motif donné (M₁) suivant une première orientation et ledit motif donné (M'₁) et suivant une deuxième orientation distincte de la première orientation.

7. Substrat selon la revendication 6, comportant plusieurs autres rangées (32, 33) parallèlement au deuxième axe (Δ₂), au moins une rangée (32) donnée étant formée d'une répétition dudit motif donné (M₁) suivant la première orientation et au moins une rangée voisine de la rangée donnée étant formée d'une répétition dudit motif donné (M'₁) suivant la deuxième orientation.

8. Substrat selon l'une des revendications 1 à 7 dans lequel lesdites régions dopées distinctes (23) sont réparties de manière périodique dans ladite structure sur une ou plusieurs autres rangées parallèlement à un deuxième axe (Δ'₂), le premier axe (Δ₁) et ledit deuxième axe (Δ'₂) étant des axes parallèles audit plan principal, ledit deuxième axe réalisant un angle inférieur à 90° avec ledit premier axe, parmi lesdites premières rangées au moins une rangée donnée étant formée d'une première succession de régions dopées reproduisant ledit motif donné, au moins une rangée voisine de ladite rangée donnée étant formée d'une deuxième succession de régions dopées reproduisant ledit motif donné, ladite rangée voisine étant décalée de ladite rangée donnée par rapport à un plan orthogonal au premier axe et audit plan principal.

9. Substrat selon l'une des revendications 1 à 8, dans lequel ledit motif donné (M₂) comporte une première branche (b₁₁), une deuxième branche (b₁₂) à une première extrémité de la première branche et réalisant un angle non-nul avec la première branche, et une troisième branche (b₁₃) à une deuxième extrémité de la première branche et réalisant un angle non-nul avec la première branche (b₁₁), la deuxième branche (b₁₂) et la troisième branche (b₁₃) ayant des orientations respectives différentes dans un plan parallèle à un plan principal de la couche de support (10).

10. Substrat selon la revendication 9, dans lequel ledit motif donné (M₃) comporte une première branche (b₂₁) principale, une deuxième branche (b₂₂) principale, une troisième branche (b₂₃) principale, une quatrième branche (b₂₄) principale, se rejoignant en un point d'intersection, et des branches secondaires (b₂₅, b₂₆, b₂₇, b₂₈) chacune située à une extrémité respective d'une branche principale, les branches secondaires (b₂₅, b₂₆, b₂₇, b₂₈) suivant des orientations respectives différentes dans un plan parallèle à un plan principal de la couche de support (10).

11. Substrat selon l'une des revendications 1 à 9, dans lequel ledit motif donné (M₄) est un motif en spirale comportant une succession de branches d'orientations respectives différentes.

12. Dispositif microélectronique comprenant :
- un substrat selon l'une des revendications 1 à 11,
- un ou plusieurs composants électroniques, en particulier un ou plusieurs transistors au moins partiellement formés dans la couche superficielle dudit substrat,
- au moins un circuit RF doté d'au moins un composant RF tel qu'une antenne ou une inductance ou un composant RF, ledit composant RF étant agencé en regard dudit secteur dopé (22).

13. Procédé de fabrication d'un substrat selon l'une des revendications 1 à 12, le procédé comprenant les étapes suivantes :
- réaliser un dopage d'un premier type d'au moins un secteur (22) d'un support semi-conducteur,
- disposer un masque (110) en regard dudit secteur (22) dopé, le masque (110) comprenant des ouvertures (111) ayant une forme reproduisant ledit motif donné,
- implanter des régions (23) dudit secteur (22) dopé à l'aide d'une espèce dopante de sorte à réaliser un dopage d'un deuxième type opposé au premier type.

14. Procédé selon la revendication 13, comprenant après ladite implantation des régions (23), des étapes de :
- formation d'une couche isolante (11) sur le support semi-conducteur, puis,
- collage sur le support d'un support muni d'une couche semi-conductrice,
- retrait d'une portion sacrificielle du substrat, tandis que la couche semi-conductrice est conservée et forme ladite couche semi-conductrice superficielle (12).

15. Procédé de réalisation d'un dispositif RF selon la revendication 11 comprenant les étapes suivantes :
- prévoir un substrat semi-conducteur sur isolant selon l'une des revendications 1 à 10 puis,
- former ledit circuit conducteur RF ou ledit composant RF en regard dudit secteur (22) dopé.
